(19) Europäisches Patentamt
European Patent Office
Office européen des brevets

(11) EP 0 685 887 B1

(12) EUROPEAN PATENT SPECIFICATION

(45) Date of publication and mention
of the grant of the patent:
01.07.1998 Bulletin 1998/27

(51) Int Cl.⁶: H01L 23/525

(21) Application number: 94830261.7

(22) Date of filing: 30.05.1994

(54) **A device for selecting design options in an integrated circuit**

Schaltung zur Auswahl von Entwurfsmöglichkeiten in einer integrierten Schaltung

Circuit pour la sélection d'options de conception dans un circuit intégré

(84) Designated Contracting States:
DE FR GB IT

(43) Date of publication of application:
06.12.1995 Bulletin 1995/49

(73) Proprietor: SGS-THOMSON
MICROELECTRONICS s.r.l.
20041 Agrate Brianza (Milano) (IT)

(72) Inventor: Confalonieri, Pierangelo
I-24040 Canonica d'Adda, Bergamo (IT)

(74) Representative: Maggioni, Claudio et al
c/o JACOBACCI & PERANI S.p.A.
Via Visconti di Modrone, 7
20122 Milano (IT)

(56) References cited:
EP-A- 0 045 895          GB-A- 2 206 730

• PATENT ABSTRACTS OF JAPAN vol. 015, no.
246 (E-1081) 24 June 1991 & JP-A-03 078 315
(NEC CORP) 3 April 1991

## Description

The present invention relates to the design of integrated semiconductor circuits and, more particularly, to a device for selecting design options in an integrated circuit.

It is known that, during the design of a complex integrated circuit, it is often impossible to establish with certainty beforehand the most advantageous circuit configuration or the most suitable component to achieve a predetermined functional effect. For example, it may be difficult, if not impossible, to evaluate the best time constant for a certain function, or the most appropriate intervention threshold for a given circuit, or the ideal current which a current-generator should supply. Moreover, it may also be useful to test a section of the integrated circuit in several different operative conditions, for example, with and without a network for correcting a parameter, in order to evaluate the effect of the correction, as in the case of an "offset"-cancelling circuit the exclusion of which would allow the magnitude of the "offset" to be evaluated.

It is also known that, during the design of an integrated circuit, it may be convenient to leave the selection between several variants of the circuit configurations and/or parameters open, to permit the production of integrated circuits the general functional characteristics of which are substantially identical, but which satisfy slightly different applicational requirements.

Essentially, to allow for the "design options" described above, it is necessary, at the design stage, to provide for modifiable connections or for selectively-addressable memory cells or registers which enable the inputs of associated circuit units to be modified so as to adopt different operative states in dependence on the states of the aforesaid modifiable connections or of the memory cells or registers.

The various options are then tested and, of these, the one which offers the functional characteristics closest to those desired is selected and the final topography of the integrated circuit to be put into production is consequently defined.

The known techniques for satisfying the design requirements described above provide for the use of terminals of the device by means of which connection may or may not be established, of fuses within the integrated circuit which can be broken by means of high currents applied between suitable terminals of the integrated circuit, of EPROM cells, of programmable register cells, or of different metallization masks for the various design options. All of these techniques, except for the last mentioned, take up quite large areas of the integrated circuit; in particular, the use of terminals of the device requires the formation of contact pads which, as is known, necessarily have large dimensions; fuses require wide metal connecting strips because of the high currents necessary to break them and are also unreliable; in addition to the space which they take up, EPROM cells also require a special manufacturing process. In any case, for all these techniques, it is necessary to provide piloting signals which, in order to control the integrated circuit, naturally have to be conducted to the corresponding points by means of suitable metal tracks which are also very bulky.

As is known to a designer of integrated circuits, after the most favourable design options have been defined, modification of the topography of the integrated circuit in order to recover the areas intended for the test components and/or connections cannot be considered, and these areas are therefore inevitably lost, detracting from the compactness of the final integrated structure.

As regards the technique which provides for different metallization masks for the various options, that is, variations in the mask for the formation of the last layer of connections in the sequence of steps of the manufacturing process, the problem is not the area taken up since, in this case, additional components or connections are not necessary, but, rather, the cost and the time necessary to put it into practice. In fact, each variant to be tested corresponds to a different mask, which itself is quite expensive, and to the manufacture of a batch of test chips, which requires a very long waiting time to evaluate the test. This technique is therefore suitable only when the number of variants to be tested is very low.

The object of the present invention is to propose a device for selecting between design options in an integrated circuit which is reliable, which has practically zero consumption, which takes up a very small area, which does not require additional masks or process steps, and which is usable without limitations on the number of variants to be tested.

This object is achieved by the provision of a device as defined and characterized in general in the first of the claims which follow the present description.

The invention will be understood better from the following description, which is given by way of example, but is in no way limiting, with reference to the appended drawings, in which:

Figure 1 is a schematic circuit diagram showing an integrated circuit comprising the device according to the invention,

Figure 2 shows a variant of the device according to the invention, again in the form of a schematic circuit diagram,

Figure 3 is a practical circuit diagram of the device of Figure 1, and

Figure 4 shows a cross-section of a portion of semiconductor material comprising the integrated circuit with a device according to the invention.

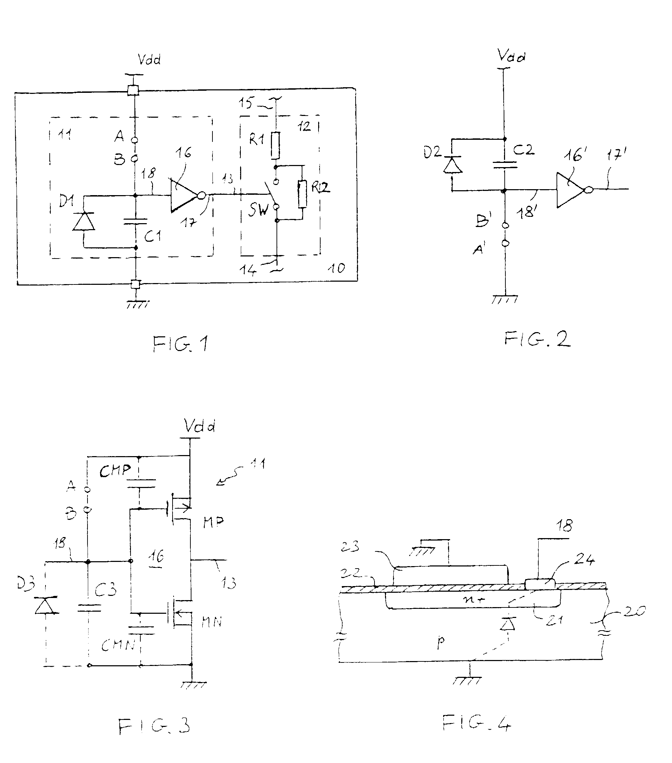

In Figure 1, an integrated circuit, indicated 10, comprises the device according to the invention, generally indicated 11, and a circuit unit 12. The latter unit represents, by way of example, a very simple form of a circuit which can adopt two different operative states in dependence on a signal applied to a control terminal thereof. It is constituted by two resistors R1 and R2 connected in series, and by an electronic switch shown as a switch SW, which is connected in parallel with one R2 of the two resistors and has a control terminal 13. Clearly, in this case, the two different operative states are two different values of the resistance between the terminals 14 and 15 of the circuit unit 12, depending upon the open or closed state of the electronic switch SW.

The selection device 11 comprises an inverter 16, of which the output 17 is connected to the control terminal 13 of the electronic switch SW, and the input terminal 18 is connected to one of the supply terminals of the integrated circuit, indicated Vdd, by means of a conductor which is arranged so as to be broken between two points A and B. The input 18 of the inverter 16 is also connected to the other supply terminal of the integrated circuit, indicated by the earth symbol, by capacitive means which, in this embodiment, is a capacitor, indicated C1, connected in parallel with a component with unidirectional conduction which, in this embodiment, is a diode D1 connected for reverse conduction.

The connection between the input 18 and the supply terminal Vdd, or at least the portion thereof between the points A and B is constituted by a conductive track, preferably of metal, which extends on the integrated circuit or, more precisely, on the surface of the "chip" of semiconductor material, on which it is formed, and can easily be recognized by the usual instruments for inspecting the surfaces of semiconductor devices and can be broken by means of a normal mechanical or laser cutting instrument.

With the connection between A and B intact, the input of the inverter 15 is at a high level and its output 17 is therefore at a low level. In these conditions, the electronic switch SW is not activated, that is, it is open and the state of the unit 12 between its terminals 14 and 15 is defined by the sum of the resistances of the two resistors R1 and R2 in series.

If the connection between the points A and B is broken, the potential at the input terminal 18 is substantially that of the earth, and the output of the inverter 16 is therefore at a high level. In these conditions, the electronic switch SW is activated, that is, it is closed, and the state of the unit 12 between its terminals 14 and 15 is defined by the resistance of the resistor R1 alone, since the resistor R2 is short-circuited by the switch SW. The function of the diode D1 is to prevent the input terminal 18, the resistance of which with respect to the earth is practically infinite, from being charged to a positive potential; this potential could reach the threshold at which the inverter is triggered as a result of any charges trapped in the dielectric of the capacitor C1 and in the input capacitance of the inverter 16 after long periods of operation of the integrated circuit. The diode D1 introduces a finite, although very high, resistance between the input terminal 18 and the earth. On the other hand, it does not affect the operation of the device when the connection between the points A and B is intact, since it is connected for reverse conduction.

Figure 2 shows the inverse version of the device 11 of Figure 1. In this case, in fact, the output terminal 17' of the inverter 16' is at a high level if the connection between its input 18' and earth is intact and is at a low level if the connection is broken. The capacitor C2 and the diode D2 have the same functions as the capacitor C1 and the diode D2 of Figure 1; they serve, respectively, to ensure that, after the connection between A' and B' has been cut, the input terminal 18' of the inverter 16' remains at a high value, that is, close to the positive supply voltage Vdd, and to constitute a finite resistance between that terminal and the terminal Vdd.

In the practical embodiment of the device according to the invention, shown in Figure 3, the inverter 16 comprises a pair of complementary field-effect transistors, that is, a p-channel transistor, indicated MP, and an n-channel transistor, indicated MN, having common drain electrodes, forming the output terminal 13, common gate electrodes, forming the input terminal 18, and source electrodes, of which one is connected to the positive supply terminal Vdd and the other to the negative supply or earth.

The diagram also shows the intrinsic capacitances CMP, CMN, existing between the gate and source terminals of the transistors MP and MN, respectively, as well as a capacitor C3 and a diode D3 which correspond, respectively, to the capacitor C1 and to the diode D1 of Figure 1. In selecting the capacitance of the capacitor C3, account must be taken of the intrinsic capacitances indicated above. It should be noted, in this connection, that the capacitance CMN increases the effect of the capacitor C3 between the input terminal 18 and the earth, whereas the capacitance CMP tends to reduce that effect. If CMN, CMP and C3 indicate the capacitances of the capacitors indicated by the same symbols in the drawing and Vs indicates the threshold of the inverter, that is, the voltage between the input terminal 18 and the earth which causes the logic state at the output terminal 13 to change, the capacitance of the capacitor C3 must satisfy the following relationship:

$$CMP/(C3 + CMN + CMP) \cdot Vdd < Vs$$

The transistors MP and MN can be of a size such that the threshold is sufficiently high and the transistor MP can be very small and hence with a low capacitance CMP, so that the capacitor C3 can be very small.

The device described above can be produced particularly advantageously by a method of manufacturing CMOS silicon integrated circuits in which the capacitors can be formed with the use, as electrodes, of a strongly doped region of the silicon substrate, for example, a region implanted with arsenic on a p-type substrate, and of an opposed portion of polycrystalline silicon, separated by a thin layer of silicon dioxide. In this case, the capacitor C3 is formed as shown in Figure 4, in which the silicon substrate is indicated 20, the strongly doped n-type region which forms the first electrode is indicated 21, the silicon dioxide which forms the dielectric is indicated 22, and the layer of polycrystalline silicon which forms the second electrode is indicated 23. A metal connection 24 formed on the surface of the region 21 leads to the gate electrodes of the two transistors (not shown), that is, to the input terminal 18 of the inverter 16, and the second electrode 23 is connected to the earth terminal, as is also the substrate 20, however, as required for CMOS integrated circuits on p-type substrates.

It should be noted that the diode D3 of Figure 3 is formed together with the capacitor C3, without the use of additional silicon area and without further process steps. As can easily be seen, the diode is in fact formed by the junction between the region 21 and the substrate 20. Similarly, with a different process, it would be possible to produce a diode the cathode of which had a certain capacitance with respect to earth, so that it would not be necessary to form an actual capacitor, since the capacitance of the diode could be used to perform the function of the capacitor C3.

As can easily be confirmed, the device according to the invention can be formed in a very small area, since it is formed solely by two signal transistors, that is, very low-power transistors, by a capacitor of small capacitance, and by a diode which, as in the embodiment described above, results intrinsically from the structure of the capacitor and, moreover, requires no control signal and therefore no additional conductive track on the integrated circuit. Furthermore, it has practically zero consumption since the currents involved are only leakage currents. In a practical embodiment on an integrated circuit with an area of 25 mm$^2$, the device according to the invention occupied an area of about 500 $\mu$m$^2$.

By way of indication, with one of the known techniques cited at the beginning, except for that which provides for different metallization masks for the different options, an area at least 10 times greater would be taken up in order to obtain similar design options.

Naturally, many of these devices may be formed at the same time on the same integrated circuit so as to enable all the possible design options to be evaluated. Once all the most favourable design variants have been identified, a single mask can be provided to define the connection layout of the integrated circuit intended for production. Any future variations will be possible by the modification solely of this mask.

Although only one embodiment of the invention has been described and illustrated, clearly many variants are possible within the scope of the same innovative concept. For example, the inverter may be replaced by non-complementary field-effect transistors, or by complementary or non-complementary bipolar transistors, according to the type of integrated circuit for which the device according to the invention is intended, and according to the manufacturing process available at the time in question.

## Claims

1. An integrated circuit with a device for selecting between design options there in, the integrated circuit (10) comprising first and second supply terminals (Vdd, earth) which can be connected to a voltage supply and at least one circuit unit (12) which can adopt two different operative states in dependence on a signal applied to a control terminal (13) thereof, characterized in that the device for selecting between design options comprises an inverter (16) having an output terminal (17) connected to the control terminal (13) of the circuit unit (12) and an input terminal (18) connected both to the first supply terminal (Vdd), by means of a conductor (A, B) which can be broken by means outside the integrated circuit, and to the second supply terminal (earth), by a capacitive means (C1) connected in parallel with a component (D1) with unidirectional conduction, connected for reverse conduction.

2. An integrated circuit according to Claim 1, in which the inverter (16) comprises a pair of complementary field-effect transistors (MP, MN) with common drain electrodes forming the output terminal (13) of the inverter (16), with common gate electrodes forming the input terminal (18) of the inverter (16), and with source electrodes of which one is connected to the first supply terminal (Vdd) and the other is connected to the second supply terminal (earth).

3. An integrated circuit according to Claim 1 or Claim 2, in which the integrated circuit (10) is formed on a substrate (20) of semiconductor material of a first conductivity type (p), in which the capacitive means (C3) comprise a first electrode constituted by a region (21) of a second conductivity type (n) formed on a surface of the substrate (20) and forming a junction therewith, a layer of dielectric material (22) which covers the surface of the substrate on this region (21), and a second electrode constituted by a layer of electrically-conductive material (23) which extends on the dielectric layer (22), above the region (21), and in which the component (D3) with unidirectional conduction comprises the junction, electrical contact means (24) being provided on the region (21) for connecting the first electrode (21) of the capacitive means (C3) and the unidirectional conduction means (D3) to the input terminal (18) of the inverter (16) and for connecting the layer of electrically-conductive material (23) and the substrate (20) to the second supply terminal (earth).

## Patentansprüche

1. Eine integrierte Schaltung mit einer Vorrichtung zum Auswählen zwischen Entwurfsoptionen, wobei die integrierte Schaltung (10) einen ersten und einen zweiten Versorgungsanschluß (Vdd, Masse), die mit einer Spannungsversorgung verbunden werden können, und mindestens eine Schaltungseinheit (12) aufweist, die zwei unterschiedliche Betriebszustände in Abhängigkeit von einem Signal annehmen kann, das an einen Steuerungsanschluß (13) derselben angelegt ist, dadurch gekennzeichnet, daß die Vorrichtung zum Auswählen zwischen Entwurfsoptionen einen Inverter (16) mit einem Ausgangsanschluß (17), der mit dem Steuerungsanschluß (13) der Schaltungseinheit (12) verbunden ist, und einen Eingangsanschluß (18) aufweist, der sowohl mit dem ersten Versorgungsanschluß (Vdd) mittels eines Leiters (A, B), der durch eine Einrichtung außerhalb der integrierten Schaltung unterbrochen werden kann, als auch mit dem zweiten Versorgungsanschluß (Masse) durch eine kapazitive Einrichtung (C1) verbunden ist, die parallel zu einer Komponente (D1) mit einer unidirektionalen Leitung geschaltet ist, die für eine Rückwärtsleitung verschaltet ist.

2. Eine integrierte Schaltung gemäß Anspruch 1, bei der der Inverter (16) ein Paar von komplementären Feldeffekttransistoren (MP, MN) mit gemeinsamen Drain-Elektroden, die den Ausgangsanschluß (13) des Inverters (16) bilden, mit gemeinsamen Gate-Elektroden, die den Eingangsanschluß (18) des Inverters (16) bilden, und mit Source-Elektroden aufweist, von denen eine mit dem ersten Versorgungsanschluß (Vdd) und die andere mit dem zweiten Versorgungsanschluß (Masse) verbunden ist.

3. Eine integrierte Schaltung gemäß Anspruch 1 oder Anspruch 2, bei der die integrierte Schaltung (10) auf einem Substrat (20) aus einem Halbleitermaterial eines ersten Leitfähigkeitstyps (p) gebildet ist, bei der die kapazitive Einrichtung (C3) eine erste Elektrode, die durch eine Region (21) eines zweiten Leitfähigkeitstyps (n), die auf einer Oberfläche des Substrats (20) gebildet ist und einen Übergang mit demselben bildet, gebildet ist, eine Schicht aus dielektrischem Material (22), das die Oberfläche des Substrats auf dieser Region (21) bedeckt, und eine zweite Elektrode aufweist, die durch eine Schicht aus elektrisch leitfähigem Material (23) gebildet ist, die sich auf der dielektrischen Schicht (22) oberhalb der Region (21) erstreckt, und bei der die Komponente (D3) mit unidirektionaler Leitung den Übergang aufweist, wobei eine elektrische Kontakteinrichtung (24) auf der Region (21) zum Verbinden der ersten Elektrode (21) der kapazitiven Einrichtung (C3) und der unidirektionalen Leitungseinrichtung (D3) mit dem Eingangsanschluß (18) des Inverters (16) und zum Verbinden der Schicht des elektrisch leitfähigen Materials (23) und des Substrats (20) mit dem zweiten Versorgungsanschluß (Masse), vorgesehen ist.

## Revendications

1. Circuit intégré comportant un dispositif pour effectuer une sélection entre des options de conception qu'il comporte, le circuit intégré (10) comprenant des première et seconde bornes d'alimentation (Vdd, masse) qui peuvent être connectées à une alimentation en tension et à au moins un module de circuit (12) qui peut passer dans deux états de fonctionnement différents, en fonction d'un signal appliqué à une borne de commande (13) de celui-ci, caractérisé en ce que le dispositif destiné à effectuer une sélection entre des options de conception comprend un inverseur (16) ayant une borne de sortie (17) connectée à la borne de commande (13) du module de circuit (12) et une borne d'entrée (18) connectée à la fois à la première borne d'alimentation (Vdd), au moyen d'un conducteur (A, B) qui peut être interrompu par des moyens extérieurs au circuit intégré, et à la seconde borne d'alimentation (masse), par des moyens capacitifs (C1) connectés en parallèle avec un composant (D1) à conduction unidirectionnelle, connecté pour une conduction en sens inverse.

2. Circuit intégré selon la revendication 1, dans lequel l'inverseur (16) comprend une paire de transistors à effet de champ complémentaires (MP, MN) ayant des électrodes de drain communes formant la borne de sortie (13) de l'inverseur (16), des électrodes de grille communes formant la borne d'entrée (18) de l'inverseur (16), et des électrodes de source dont une est connectée à la première borne d'alimentation (Vdd) et dont l'autre est connectée à la seconde borne d'alimentation (masse).

3. Circuit intégré selon la revendication 1 ou la revendication 2, dans lequel le circuit intégré (10) est formé sur un substrat (20) constitué d'un matériau semiconducteur ayant un premier type de conductivité (p), dans lequel les moyens capacitifs (C3) comprennent une première électrode constituée par une région (21) d'un second type de conductivité (n) formée sur une surface du substrat (20) et formant une jonction avec celui-ci, une couche de matériau diélectrique (22) qui recouvre la surface du substrat sur cette région (21), et une seconde électrode constituée par une couche de matériau électriquement conducteur (23) qui s'étend sur la couche diélectrique (22), au-dessus de la région (21), et dans lequel le composant (D3) à conduction unidirectionnelle comprend la jonction, des moyens de contact électrique (24) étant prévus sur la région (21) pour connecter la première électrode (21) des moyens capacitifs (C3) et les moyens à conduction unidirectionnelle (D3) à la borne d'entrée (18) de l'inverseur (16) et pour connecter la couche de matériau électriquement conducteur (23) et le substrat (20) à la seconde borne d'alimentation (masse).

FIG. 1

FIG. 2

FIG. 3

FIG. 4